# EUROPÄISCHE PATENTSCHRIFT

(11) **EP 2 052 451 B1**
(45) Veröffentlichungstag und Bekanntmachung des Hinweises auf die Patenterteilung: **14.07.2010**
(21) Anmeldenummer: 06775872.2
(22) Anmeldetag: 15.08.2006
(51) Int. Cl.: H02J 3/00

(54) **MODELLBASIERTES VERFAHREN ZUR ÜBERWACHUNG EINES ENERGIEVERSORGUNGSNETZES UND SYSTEM ZUR DURCHFÜHRUNG DES VERFAHRENS**
MODEL-BASED METHOD FOR MONITORING A POWER SUPPLY NETWORK, AND SYSTEM FOR CARRYING OUT SAID METHOD
PROCEDE A BASE DE MODELE POUR SURVEILLER UN RESEAU D'ALIMENTATION EN ENERGIE ET SYSTEME POUR METTRE LE PROCEDE EN OEUVRE

(43) Veröffentlichungstag der Anmeldung: 29.04.2009
(73) Patentinhaber: SIEMENS AKTIENGESELLSCHAFT, 80333 München (DE)
(72) Erfinder: KREBS, Rainer, 91052 Erlangen (DE); LEMMER, Siegfrid, 91096 Möhrendorf (DE); REINDERS, Christian, 14469 Potsdam (DE); RETZMANN, Dietmar, 91315 Höchstadt (DE); WEINHOLD, Michael, 91056 Erlangen (DE)
(86) Internationale Anmeldenummer: PCT/DE2006/001446
(87) Internationale Veröffentlichungsnummer: WO 2008/019634

(56) Entgegenhaltungen:
- EP-A1- 1 324 455
- WO-A-99/60417
- US-A- 5 625 751

## Beschreibung

Die Erfindung betrifft ein modellbasiertes Verfahren zur Überwachung eines Energieversorgungsnetzes, wobei das Energieversorgungsnetz mindestens eine Messeinrichtung zur Messung von Messwerten mindestens einer Messgröße des Energieversorgungsnetzes aufweist. Weiterhin betrifft die Erfindung ein System zur Überwachung eines Energieversorgungsnetzes mit mindestens einer Messeinrichtung zur Messung von Messwerten mindestens einer Messgröße des Energieversorgungsnetzes.

Energieversorgungsnetze, insbesondere elektrische Hochspannungsnetze, sind hoch komplexe Netzwerke, die nur mittels eines hohen Aufwandes überwacht und gesteuert werden können. Zusätzlich verursachen die Liberalisierung der Energiemärkte sowie eine Dezentralisierung der Erzeugungseinheiten, wie z.B. zusätzliche Windparks in einem Energieversorgungsnetz, so dass die Stabilität des Energieversorgungsnetzes räumlich und zeitlich stark schwanken kann. Dies erfordert einen vermehrten Aufwand hinsichtlich der Überwachung und Regelung der Lastflüsse innerhalb eines Energieversorgungsnetzes, um eine Überbeanspruchung bis hin zum Totalausfall des Energieversorgungssystems zu vermeiden.

Herkömmlicherweise wird der Zustand eines Energieversorgungsnetzes auf der Grundlage von Messdaten bestimmter Parameter des Energieversorgungsnetzes, wie zum Beispiel dem Strom, der Spannung und/oder dem Phasenwinkel zwischen dem Strom und der Spannung, über einen bestimmten Zeitraum erfasst und gemittelt, zumeist 30 Sekunden. Anschließend werden die gemittelten Messdaten und an eine Leitwarte übersandt. In der Leitwarte wertet und interpretiert ein Bediener mit Hilfe seiner häufig langjährigen Erfahrung diese zumeist als alphanumerische Werte oder als Graphen visualisierten Messdaten aus und nimmt anhand diese Datengrundlage die gegebenenfalls notwendigen Änderungen der Netzkonfiguration vor.

So beschreibt als Beispiel für den Stand der Technik die EP 1 408 595 A1 ein Verfahren zur Bestimmung von Parametern eines Ersatzschaltbildes der Übergangssektion eines elektrischen Netzes. Gemäß der dortigen Erfindung wird eine mögliche Spannungsinstabilität mittels der Messung von Spannungen und Strömen innerhalb des Netzwerkes analysiert. Auf der Grundlage einer mathematischen Formel wird mit Hilfe der gemessenen Spannungen und Ströme innerhalb des Netzes ein so genannter Instabilitätsparameter generiert. Der Instabilitätsparameter erlaubt entsprechend der dortigen Erfindung dann Rückschlüsse auf die Stabilität des Energieversorgungsnetzes. Gleiches offenbart die EP 1 217 709 als Verfahren und Vorrichtung zur Stabilitätsauswertung eines Energieübertragungssystems.

Eine Parameterschätzung für ein Energieversorgungsnetz ist ebenfalls in der 1 381 132 A1 offenbart. Im Rahmen des dortigen Verfahrens wird eine Vielzahl von Messdaten an unterschiedlichen Punkten des Energieversorgungsnetzes gemessen. Mittels eines mathematischen Modells wird die Abhängigkeit der Last von der derzeitigen Frequenz innerhalb des Energieversorgungsnetzes sowie die Abhängigkeit der Spannung von der derzeitigen Frequenz ermittelt.

Die WO 99/60417 offenbart ein Verfahren zur Überprüfung von elektrischen Freileitungen, damit Fehlstellen ermittelt werden können. Das Verfahren besteht darin, elektromagnetische Signale in der Nähe der Freileitungen über eine Antenne zum Messen und die aufgezeichneten Messsignale in mindestens zwei Frequenzbändern mittels eines Signalsplitters aufzuspalten und im Frequenzbereich zu analysieren. Hierdurch soll es möglich sein, unterschiedliche Netzzustände in unterschiedlichen Frequenzbereichen zu detektieren.

Des Weiteren offenbart die EP 1 324 455 B1 eine Zustandsbestimmung für Energieverteilungsnetze. Gegenstand der dortigen Erfindung ist ein Verfahren zum Abschätzen eines Zustandes eines Energieverteilungsnetzes, wobei Zeigermesseinheiten an verschiedenen Standorten innerhalb des Netzes mit einer Zeit versehen sind und entsprechend der Zeigermessungen vorgenommen werden, wobei mehrere Spannungs-Stromzeiger an einem zweiten Satz von Standorten abgeschätzt werden und aus dem Zustand der Netzelemente auf entsprechende Netzzustände geschlossen werden soll.

Ebenfalls offenbart die US 5,625,751 ein neuronales Netz zur Detektion von Fehlern innerhalb eines Energieversorgungsnetzes.

Nachteilig an allen im Stand der Technik bekannten Überwachungsverfahren eines Energieversorgungsnetzes sind, dass die Netzstabilität auf der Grundlage ausgewählter Messdaten ermittelt wird und der Bediener des Energieversorgungsnetzes auf der Grundlage des so ermittelten Netzzustandes zwar eine Vielzahl zusätzlicher Informationen angezeigt bekommt, diese Informationen jedoch weiterhin hauptsächlich aufgrund der persönlichen Erfahrung des Bedieners als Entscheidungsgrundlage für mögliche Veränderungen des Netzzustandes verwendet werden. Der Umgang des Bedieners mit diesen unkommentiert zusammengestellten Informationen ist damit vom jeweiligen Bediener und gegebenenfalls von seiner Tagesform jeweils subjektiv abhängig, was bei der gleichzeitigen Erhöhung der Komplexität der Netzkonfigurationen aufgrund der gestiegenen Netzanforderungen sich nachteilig auswirken kann.

Aufgabe der vorliegenden Erfindung ist es daher ein Verfahren zur Überwachung eines Energieversorgungsnetzes bereitzustellen, das den Bediener bei der Überwachung eines Energieversorgungsnetzes einen größtmöglichen Informationsüberblick über insbesondere kritische Zustände des Energieversorgungsnetzes gibt. Gelöst wird die Aufgabe durch die Merkmale des Patentanspruchs 1 und die Merkmale des Patentanspruchs 18. Erfindungsgemäß ist vorgesehen, dass die Messwerte mindestens einer Messgröße gemessen und mindestens zwei unterschiedlichen Abtastraten mittels der Messeinrichtung ermittelt werden, wobei die mit der ersten Abtastrate abgetasteten Messwerte zur Erzeugung einer ersten Modellabbildung des Energieversorgungsnetzes und gleichzeitig die mit der zweiten Abtastrate abgetasteten Messwerte zur Erzeugung mindestens einer zweiten Modellabbildung des Energieversorgungsnetzes genutzt und anschließend aus den Modellabbildungen Netzzustände des Energieversorgungsnetzes abgeleitet werden. Die Messeinrichtungen befinden sich vorzugsweise in einem Netzgerät innerhalb des Energieversorgungsnetzes, wie zum Beispiel einem Schutzgerät.

Energieversorgungsnetz im Sinne der vorliegenden Erfindung ist jedes Rohr- und/oder Leitungs- und/oder Funknetz über das Energie transportiert oder transformiert werden kann, wie z.B. die Weiterleitung von elektrischer Leistung über ein Hochspannungsnetz. Von der Definition sind ebenfalls Energieversorgungssysteme für fluide Medien umfasst, wie zum Beispiel die druckgesteuerte Durchleitung von Erdgas durch ein Gaspipeline-System.

Der Vorteil der vorliegenden Erfindung liegt insbesondere darin, dass nicht nur die gesamte Bandbreite der in einem Energieversorgungsnetzes zur Verfügung stehenden Messdaten für die Ermittlung eines Netzzustandes genutzt werden, sondern gleichfalls frequenzabhängige und/oder zeitlich sehr kurz- bzw. langfristige Änderungen der Netzzustände durch die Nutzung von unterschiedlich zeitlich abgetasteten Messwerten ermittelt und dargestellt werden. Hierdurch ist es möglich, dass insbesondere zeitlich sehr kurzfristige Änderungen des Netzzustandes aus Abweichungen zwischen der ernsten und der zweiten Modellabbildung abgeleitet werden können.

Vorteilhafterweise werden die Messwerte mindestens einer Messgröße des Energieversorgungsnetzes von mindestens einer zweiten Messeinrichtung gleichzeitig gemessen. Die Modellabbildungen werden anschließend auf der Basis der Messwerte mindestens einer Messgröße durch regelbasierte Systeme, wie z.B. Expertensysteme, neuronale Netze und/oder Fuzzy-Logik-Systeme, aus den ermittelten Messwerten abgeleitet. Durch diese "intelligenten" regelbasierten Systeme bietet sich im Rahmen des erfindungsgemäßen Verfahrens die Möglichkeit, die Abweichungen der zum Teil hoch komplexen und umfangreichen Datenmengen der Modellabbildungen zu bestimmen. Gleiches gilt insbesondere für die Festlegung eines Ähnlichkeitsmaßes zwischen der ersten und der zweiten Modellabbildung.

Für den Fall eines hohen Ähnlichkeitsmaßes zwischen der ersten und der zweiten Modellabbildung kann eine frequenzbedingte bzw. eine zeitliche kurzfristige Änderung des aktuellen Netzzustandes ausgeschlossen werden. Eine kurzfristige Änderung des Netzzustandes kann damit für diese miteinander verglichenen Modellabbildungen ausgeschlossen werden. Sollte umgekehrt nur ein geringes Ähnlichkeitsmaß zwischen der ersten und zweiten Modellabbildung vorliegen, ist von einer zeitlich sehr kurzfristigen Änderung des Netzzustandes auszugehen. Idealerweise sind die Modellabbildungen unabhängig von den Abtastraten bei der Messung der Messwerte, so dass die ermittelten Netzzustände der ersten und der zweiten Modellabbildung in diesem Falle gleich sein sollten.

Es wird als Vorteil angesehen, dass die erste und die zweite Modellabbildung zu einer übergeordneten Modellabbildung zusammengefasst werden. Gegebenenfalls nicht übereinstimmende Modellregionen werden mittels herkömmlicher graphischer Ausgleichsfunktionen beziehungsweise durch einen Ausgleich der zugrunde liegenden Messdaten der betreffenden Modellabbildungen interpoliert und anschließend wird die nicht übereinstimmende Modellregion innerhalb der übergeordneten Modellabbildung nachmodelliert. Durch diese vorteilhafte Maßnahme ergeben sich vielfältige Möglichkeiten zur Analyse der ersten und zweiten Modellabbildung sowie mittels der hieraus abgeleiteten übergeordneten Modellabbildungen.

Für den Fall einer vollständigen übereinstimmung und damit des höchstmöglichen Ähnlichkeitsmaßes zwischen der ersten und der zweiten Modellabbildung entspricht die übergeordnete Modellabbildung den zugrunde gelegten Modellabbildungen. Für den Fall eines geringen Ähnlichkeitsmaßes zwischen der ersten und der zweiten Modellabbildung sind Interpolationen in bestimmten Modellregionen der übergeordneten Modellabbildung notwendig. Diese Interpolationen sind in erster mathematischer Nährung eine Mittlung über die entsprechenden Abtastraten der zugrunde liegenden Messwerte. Durch diese Interpolationen ergibt sich die Möglichkeit, dass die erste und/oder die zweite und/oder die übergeordnete Modellabbildung mit archivierten Modellabbildungen verglichen und im Falle der Übereinstimmung der zugrunde liegenden Modellabbildungen mit einer archivierten Modellabbildung eines möglichen kritischen Netzzustandes weitere Maßnahmen zur Beilegung bzw. Vermeidung eines kritischen Netzzustandes eingeleitet werden.

Insbesondere ist vorgesehen, dass ein priorisierter Zugriff auf die Messeinrichtung zur Ermittlung einer größeren Anzahl von Messwerten und Messwerten von weiteren Messgrößen erfolgt und anschließend auf dieser erweiterten Datengrundlage der Messwerte hieraus abgeleiteten Modellabbildungen und/oder abgeleiteten Netzzustände mit relevanten archivierten Modellabbildungen bzw. Netzzuständen, insbesondere kritischer Netzzuständen, verglichen werden.

Gleichzeitig kann dem Bediener zur Überwachung des Energieversorgungsnetzes die Übereinstimmung einer Modellabbildung mit einer archivierten Modellabbildung eines kritischen Netzzustandes angezeigt, sowie die erweitere Datengrundlage der Messewerte direkt angezeigt werden. Dem Bediener des Energieversorgungsnetzes wird im Falle der Detektion eines möglichen kritischen Netzzustandes eine Art "Informationsfenster" geöffnet, so dass dem Bediener mittels der nun umfangreicher angezeigten Messdaten einen tiefergehenden Einblick in den aktuellen Netzzustand eröffnet. Die Informationsdichte der dem Bediener zur Überwachung des Energieversorgungsnetzes bereitgestellten Mess- und Modelldaten wird in Abhängigkeit eines vom Verfahren detektierten möglichen kritischen Netzzustandes geregelt, sowie die gegebenenfalls möglichen Maßnahmen zur Beilegung bzw. Vermeidung eines kritischen Netzzustandes.

Durch diese erfindungsgemäße Maßnahme wird im Falle der Detektion eines möglicherweise kritischen Netzzustandes auf der Basis einer eingeschränkten Datengrundlage von Messwerten zur Erzeugung von lediglich zwei Modellabbildungen mit unterschiedlichen Abtastraten das Überwachungssystem sensibilisiert und in eine andere Aktivitätsstufe geschaltet. Aufgrund dieser Sensibilisierung auf einen möglichen kritischen und/oder optimalen Netzzustand überprüft das Überwachungssystem den aktuellen Netzzustand auf einer verbreiterten Datengrundlage indem nunmehr wesentlich intensiver und in zeitlich kürzeren Abständen als in der vorhergehenden Aktivitätsstufe die Messdaten ermittelt und die hieraus abgeleiten Modellabbildungen analysiert werden. Idealerweise wird gleichzeitig die Datengrundlage der Messdaten vergrößert, indem zusätzliche Messdaten mit weiteren unterschiedlichen Abtastraten sowie weitere Messdaten anderer Messgrößen ermittelt werden.

Hierdurch wird gemäß der Erfindung ein zweistufiges Überwachungssystem eines Energieversorgungsnetzes zur Verfügung gestellt, das auf einer Auswertung einer ersten Modellabbildung von Messdaten und der Auswertung der damit verbundenen Netzzustände eine tiefergehende Analyse der Netzzustände vornimmt. Bei der Detektion eines möglichen kritischen Netzzustandes beziehungsweise bei Erreichen eines optimalen Netzzustandes nimmt das vorliegende Verfahren zur Überwachung eines Energieversorgungsnetzes eine noch genauere Auswertung der im Energieversorgungsnetz zur Verfügung stehenden Messdaten vor. Insbesondere die Auswertung von zeitlich unterschiedlich abgetasteten Messdaten über unterschiedliche Zeitbereiche wird als verbreiterte Datengrundlage der Messwerte dazu genutzt, die bereits getroffene Einschätzung eines möglichen kritischen oder optimalen Netzzustandes durch eine genauere Messdatenauswertung zu verifizieren. Ergibt sich aus den detailliert aufgenommenen Messdaten erneut ein möglicher kritischer Netzzustand, können hieraus vorteilhafterweise insbesondere Warnmeldungen und/oder Steuerungsbefehle für relevante Netzgeräte bzw. Handlungsoptionen für einen Bediener zur Überwachungen generiert werden. Im Falle eines verifizierten optimalen Netzzustandes werden die ermittelten Messwerte archiviert und als zukünftige Vergleichswerte einer optimalen Netzkonfiguration genutzt.

Idealerweise erfolgt die Bestimmung des relevanten Netzgerätes sowie die aufgrund der derzeitigen Netzkonfigurationen notwendigen Handlungsoptionen und Steuerbefehle für das relevante Netzgerät mittels regelbasierter Systeme, wie z.B. Expertensysteme, neuronale Netze und/oder Fuzzy-Logik-Systeme.

Weiterhin werden aktuelle und/oder zukünftige Netzzustände aufgrund der ermittelten aktuellen Messwerte berechnet und insbesondere dem Bediener zur Überwachung des Energieversorgungsnetzes die Messwerte und/oder Modellabbildungen und/oder die Handlungsoptionen oder Steuerungsbefehle der relevanten Netzgeräte visualisiert. Die Berechnungen der Modellabbildungen, der Ähnlichkeitsmaße, der Handlungsoptionen und/oder der Steuerungsbefehle für relevante Netzgeräte werden in einer zentralen Recheneinheit durchgeführt. Alternativ können in einem Rechnerverbund dezentral Rechenkapazitäten, insbesondere durch peer-to-peer-Kommunikationsverbindungen, bereitgestellt werden.

Gleichsam wird es als Vorteil angesehen, dass die durch die Messeinrichtung zur Verfügung gestellten Messwerten nach vorgegebenen Filterverfahren gefiltert beziehungsweise erst im Falle der Überschreitung von vorgebbaren Schwellwerten der Recheneinheit zur Verfügung gestellt werden. Hierdurch wird, insbesondere für die Erzeugung der ersten und zweiten Modellabbildung, die Datenmengen der ermittelten Messdaten und damit die notwendige Rechenkapazität reduziert. Es wird damit nicht nur der Informationsfluss der dem Bediener zur Überwachung des Energieversorgungsnetzes angezeigten Daten und Modellabbildungen selektiv gesteuert, sondern ebenfalls die Datengrundlage der Messwerte zur Erzeugung der Modellabbildungen situationsabhängig verändert.

Die Modellabbildungen werden als Grundlage zur Berechnung eines Netzzuverlässigkeitsindizes als Maß für die Versorgungssicherheit und/oder Netzstabilität des Energieversorgungsnetzes verwendet. Insbesondere die Anzeige der Netzstabilitätindizes bietet dem Bediener zur Überwachung des Energieversorgungsnetzes die Möglichkeit schnell und intuitiv den Zustand des von ihm zu überwachten Energieversorgungsnetzes zu erfassen. Idealerweise ist die Messgröße der ermittelten Messdaten zumindest teilweise der Phasenwinkel zwischen dem Strom und der Spannung innerhalb des Energieversorgungsnetzes.

Die Erfindung wird ebenfalls dadurch gelöst, dass die Messwerte der mindestens einen Messgröße in der Messeinrichtung messbar und die Messwerte mit mindestens zwei unterschiedlichen Abtastraten abtastbar sind, wobei für eine Recheneinheit die mit der ersten Abtastrate abgetasteten Messwerte zur Erzeugung einer ersten Modellabbildung des Energieversorgungsnetzes und die mit der zweiten Abtastrate abgetasteten Messwerte zur Erzeugung einer zweiten Modellabbildung des Energieversorgungsnetzes einlesbar und damit aus den Modellabbildungen Netzzustände des Energieversorgungssystems ableitbar sind. Vorteilhafterweise ist die Messeinrichtung Bestandteil eines Phasenvektorgerätes. Ebenfalls sind Störschriebe von Schutzgeräten und Messwerte von Messumformern relevante Messdaten im Sinne der vorliegenden Erfindung.

Es wird als Vorteil angesehen, dass die Messeinrichtung die Messwerte ermittelt und die Messwerte über ein Kommunikationsnetz versendet. Die Verwendung eines eigenständigen Kommunikationsnetzes stellt sicher, dass im Falle eines Netzausfalls des Energieversorgungsnetzes die mit dem Ausfall verbundenen Messdaten an die Recheinheit übertragbar und damit der kritische Netzzustand schnell abgebildet werden kann. Über das Kommunikationsnetz können ebenfalls die Steuerungsbefehle für die relevanten Netzgeräte übermittelt werden. Des Weiteren kann das Kommunikationsnetz durch die Recheneinheit im Falle eines ermittelten möglichen kritischen Netzzustandes dazu genutzt werden, Zustandsparameter von ausgewählten Netzgeräten, wie z.B. die Abtastrate einer im Netzgerät integrierten Messvorrichtung, zu verändern und damit situationsabhängig die Datengrundlage zu verbreitern.

Die vorliegende Erfindung kann in Form von Hardware, Software oder einer Kombination von Hardware und Software realisiert werden. Hierfür ist jede Art von System bzw. jede andere zum Ausführen des erfindungsgemäßen Verfahrens eingerichtete Vorrichtung geeignet. Eine typische Kombination von Hardware und Software könnte ein Universalcomputersystem mit einem Computerprogramm sein, welches in das Universalcomputersystem geladen und ausgeführt wird und das Computersystem so steuert, dass eine nach dem beschriebenen Verfahren erstellte Applikation ausführt. In einer weiteren Kombination von Hardware und Software kann beispielsweise zur Überwachung eines Energieversorgungsnetzes ein Messwert mit unterschiedlichen Abtastraten in einer Messeinrichtung eines Netzgerät ermittelt und in einer Simulationseinheit als jeweilige Modellabbildung des Energieversorgungsnetzes simuliert werden, wobei anschließend die Modellabbildungen miteinander verglichen und Abweichungen festgestellt werden. Die vorliegende Erfindung kann auch in ein Computerprogrammprodukt integriert werden, welches alle Merkmale umfasst, die es zur Realisierung der hier beschriebenen computergestützten Verfahren befähigen, und welches nach dem Laden in ein Computersystem in der Lage ist, diese Verfahren auszuführen.

Unter den Begriffen Computerprogrammmittel, Computerprogramm und Computeranwendung ist im vorliegenden Zusammenhang jeder Ausdruck in einer beliebigen Computersprache, Code oder Notation eines Satzes von Anweisungen zu verstehen, welche ein Computersystem zur Datenverarbeitung und so zur Ausführung einer bestimmten Funktion befähigen. Das Computerprogrammmittel, das Computerprogramm bzw. die Computeranwendung ist entweder direkt oder nach einer Umwandlung in eine andere Sprache, Code, Notation oder durch die Darstellung in einer anderen materiellen Form auf dem Computersystem lauffähig.

Weitere vorteilhafte Ausführungsformen ergeben sich aus den Unteransprüchen.

Die Erfindung wird anhand von Ausführungsbeispielen in den Zeichnungen näher erläutert. Es zeigen:
- Fig. 1: schematisches Flussdiagramm bezüglich des Ab- laufs des erfindungsgemäßen Verfahrens;
- Fig. 2: schematische Darstellung der Messdatenaufbe- reitung gemäß dem erfindungsgemäßen Verfahren.

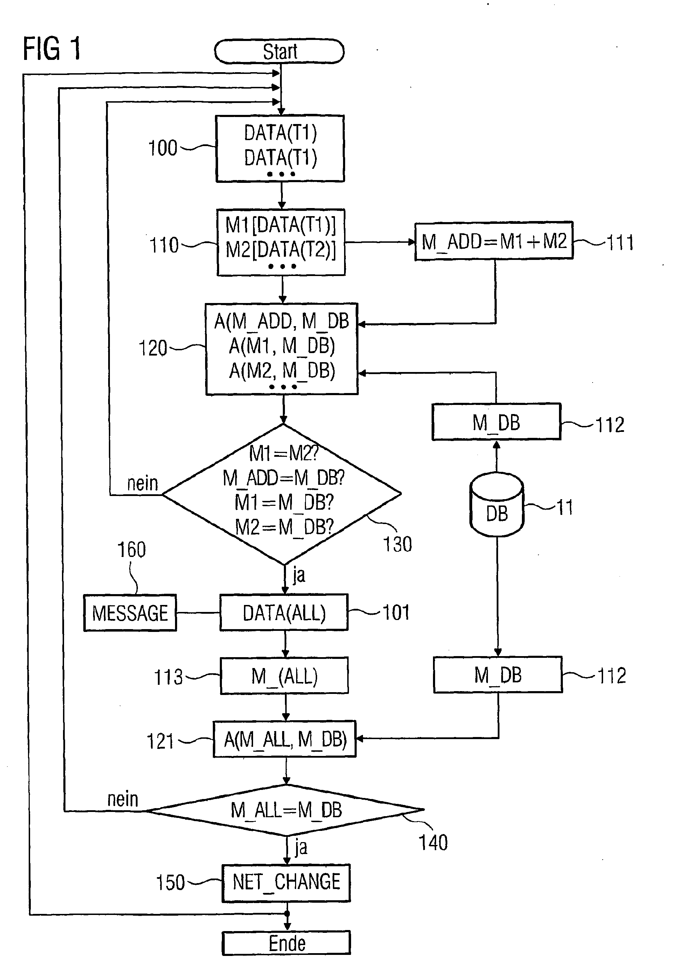

Die Figur Fig. 1 zeigt ein Flussdiagramm der wichtigsten Verfahrensschritte des erfindungsgemäßen Verfahrens. Nach der Datenakquise der hinreichenden Messwerte 100 bezüglich zweier unterschiedlicher Abtastraten werden aus den so gewonnenen Messwerten 100 eine entsprechende erste und zweite Modellabbildung 110a, 110b erzeugt. Anschließend wird die erste 110a und die zweite Modellabbildung 110b zu einer übergeordneten Modellabbildung 111 zusammengefasst. Die so ermittelten Modellabbildungen 110a, 110b, 111 werden mit einer in einer Datenbank 11 abgelegten Modellabbildung 112 verglichen.

Insbesondere kritische Netzzustände sind als Modellabbildungen 112 in der Datenbank 11 archiviert. Diese ermittelten und archivierten Modellabbildungen 110a, 110b, 111, 112 werden nunmehr miteinander verglichen und mittels regelbasierter Systeme 13, insbesondere durch Expertensysteme, ein entsprechendes Ähnlichkeitsmaß 120 der jeweiligen miteinander verglichenen Modellabbildungen 110a, 110b, 111, 112 ermittelt.

Modellabbildung 110a, 110b, 111, 112 ermittelt im Sinne der vorliegenden Erfindung ist dabei jedwede graphische Darstellung und Angabe von Werte zur Charakterisierung eines Energieversorgungsnetzes. Neben graphischen Darstellungen des Netzzustandes, beispielsweise die farbkodierte Darstellung der Spannungshöhe innerhalb eines Energieversorgungsnetzes, bis hin zu einzelnen alphanumerischen Werten, sind Modellabbildungen 110a, 110b, 111, 112 gemäß der vorliegenden Erfindung.

Auf der Grundlage der so ermittelten Ähnlichkeitsmaße 120 wird ein Vergleich 130 im dargestellten Beispiel aller zur Verfügung stehenden ermittelten Modellabbildungen 110a, 110b, 111 mit der archivierten Modellabbildung 112, insbesondere eines möglichen kritischen Netzzustandes, vorgenommen. Sollte im Rahmen der Vergleichsoperation 130 eine Korrespondenz der ermittelten Modellabbildungen 110a, 110b, 111 und der archivierten Modellabbildung 112 in Verbindung mit einem hohen Ähnlichkeitsmaß 120 nicht vorliegen, kann auf einem unkritischen aktuellen Netzzustand des Energieversorgungsnetzes geschlossen werden und die bisher Form der Datenakquise der hinreichenden Messwerte (100) fortgeführt werden.

Für den Fall, dass eine ermittelte Modellabbildung 110a, 110b, 111 mit der archivierten Modellabbildung 112 eines kritischen Netzzustandes übereinstimmt und ein hohes Ähnlichkeitsmaß 120 hierfür vorliegt, nimmt das System eigenständig eine Erhöhung des Aktivitätsniveaus vor. Nun wird auf der Grundlage des vorerst als möglicherweise kritisch festgestellten Netzzustandes eine Datenakquise auf der Basis einer erweiterten Datengrundlage von erweiterten Messwerte (101) vorgenommen. Insbesondere erweiterte Messwerte (101) mit weiteren Abtastraten sowie bisher noch nicht für die Modellabbildung genutzte Messwerte anderer Messgrößen werden nunmehr explizit akquiriert und schnellstmöglich für die Berechnung einer entsprechenden Modellabbildung 110a, 110b, 111 verwendet.

Die so ermittelten Modellabbildungen 110a, 110b, 111 werden wiederum mit archivierten Modellabbildungen 112 von möglichen kritischen Netzzuständen verglichen. Gleichzeitig wird dem Bediener zur Überwachung des Energieversorgungsnetzes diese Veränderung der Aktivierungsschwelle angezeigt. Im vorliegenden Beispiel ist der Verfahrensablauf so gewählt, dass die aufgrund der Anhebung der Aktivierungsschwelle innerhalb des Überwachungssystems und des gleichzeitigen priorisierten Zugriffs auf möglichst viele erweiterte Messwerte (101) unterschiedlichster Messgrößen hieraus abgeleitete Modellabbildungen 110a, 110b, 111 wiederum mit archivierten Modellabbildungen 112 von kritischen Netzzuständen verglichen und anschließend Warnmeldungen 160 Steuerungsbefehle 150 für relevante Netzgeräte 15 und/oder Handlungsoptionen 170 für einen Bediener erzeugt werden. Vorausgesetzt, dass der zweite Vergleichsoperator 140 wiederum einen kritischen Netzzustand bestätigt.

Gleichsam kann jedoch auch dem Bediener aufgrund der erstmalig detektierten Übereinstimmung zwischen einer ermittelten Modellabbildung 110a, 110b, 111 und einer archivierten Modellabbildung 112 für einen kritischen Netzzustand eine Visualisierung der erweiterten Messwerte (101) und hieraus abgeleiteter Modelldaten 110a, 110b, 111, 112 des Energieversorgungsnetzes angezeigt werden. Vorteilhafterweise sollten diese erweiterten Messwerte (101) dann direkt und online dem Bediener zur Überwachung eines Energieversorgungsnetzes angezeigt werden.

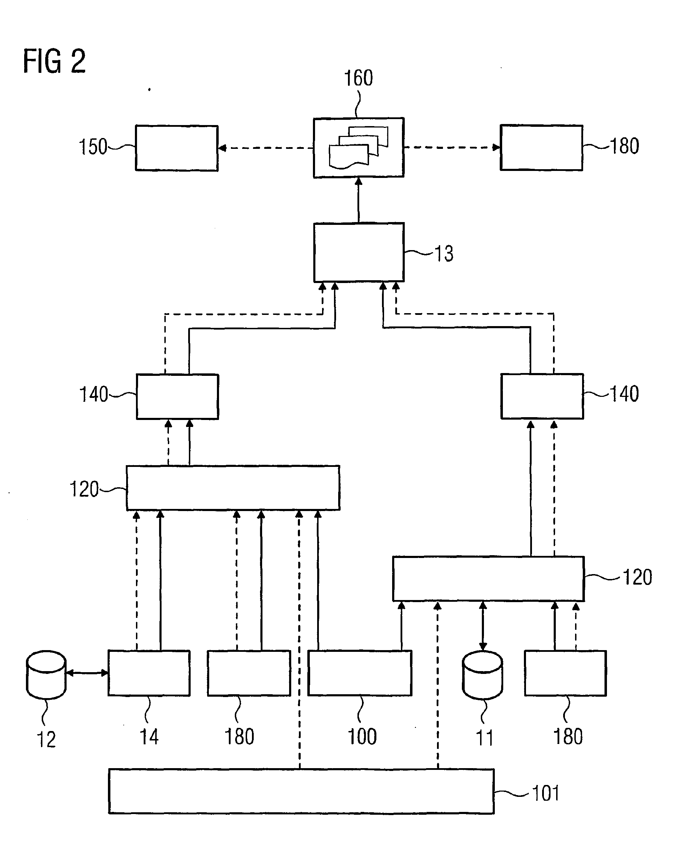

Die Figur Fig. 2 zeigt eine schematische Darstellung der prinzipiellen Datenaufbereitung gemäß dem erfindungsgemäßen Verfahren. Vorteilhafterweise wird das erfindungsgemäße Verfahren zweigeteilt, indem die aus dem Energieversorgungsnetz ermittelten hinreichenden Messwerte (100) zu entsprechenden Modellabbildungen 110a, 110b, 111 zusammengefasst und anschließend diese Modellabbildungen 110a, 110b, 111 miteinander verglichen und Abweichungen festgestellt werden. Ebenfalls wird ein Vergleich zwischen den ermittelten Modellabbildungen 110a, 110b, 111 und archivierten Modellabbildungen 112 parallel vorgenommen und an eine zentrale Recheneinheit 10 (nicht dargestellt) weitergeleitet. Gleichzeitig wird die Netzstruktur 180 ermittelt und bei der Ermittlung der Ähnlichkeitsmaße 120, 121 berücksichtigt.

Für den Fall, dass in der zentralen Recheneinheit 10 ein möglicher kritischer Netzzustand detektiert wird, wird durch die Recheneinheit 10 eine Abfrage der nun erweiterten Messwerte 101 initiiert. Bei dieser zweiten Abfrage werden wesentlich größere Datengrundlagen an Messwerten 101, insbesondere über höchst unterschiedliche Abtastraten und Messgrößen, initiiert. Hierdurch wird es möglich, diesen möglicherweise kritischen Netzzustand anhand von anderen Messgrößen und/oder anderen aktuellen Messwerten auf einer breiteren Datengrundlage zu verifizieren. Dieser zweite Verfahrensablauf ist durch die gestrichelten Pfeile in der Figur Fig. 2 dargestellt.

Dieser zweite Durchlauf der erweiterten Messwerte (101) zur Ermittlung der Modellabbildungen 110a, 110b, 111 wird innerhalb der Recheneinheit 10 priorisiert vorgenommen und eine entsprechende Warnmeldung 160 bei einer erneuten Bestätigung eines vorliegenden möglichen kritischen Netzzustandes ausgegeben. Diese Warnmeldung 160 kann entweder als Meldung dem Bediener der zur Überwachung des Energieversorgungsnetzes angezeigt beziehungsweise gleichzeitig ein Steuerungsbefehl 150 für ein als relevant ermitteltes Netzgerät 15 erzeugt werden. Im Rahmen der Anzeige der Warnmeldung 160 für den Bediener zur Überwachung des Energieversorgungsnetzes können ebenfalls direkt die erweiterten Messwerte 101 angezeigt werden.

Hierdurch erhält der Bediener nicht nur einen Hinweis auf den erstmalig detektierten möglichen kritischen Netzzustandes, sondern ebenfalls die detailierteren Messwerte 101 zur Abbildung des aktuellen Netzzustandes des Energieversorgungsnetzes. Die sich für den Bediener zur Überwachung des Energieversorgungsnetzes gegebenenfalls schon aus den visualisierten erweiterten Messwerten 101 ergebenden Unregelmäßigkeiten bezüglich der Netzstabilität können dann direkt durch den Bediener erfasst und gegebenenfalls entsprechende Gegenmaßnahmen eingeleitet werden.

### Bezugszeichenliste

- 10: Recheneinheit
- 11: Datenbank archivierter Modelabbildungen
- 12: Datenbank simulierter Modellabbildungen
- 13: regelbasiertes System
- 14: Simulationseinheit
- 15: Netzgerät
- 16: Messeinrichtung
- 100: hinreichende Messwerte
- 101: erweiterte Messwerte
- 110a, 110b: erste, zweite Modellabbildung
- 111: übergeordnete Modellabbildung
- 112: archivierte Modellabbildung
- 113: Modellabbildung der erweiterten Messwerte
- 120: Ermittlung des Ähnlichkeitsmaßes bezüg- lich der hinreichenden Messwerte
- 121: Ermittlung des Ähnlichkeitsmaßes bezüg- lich der erweiterten Messwerte
- 130: Vergleichsoperator Modellabbildung bezüg- lich der hinreichenden Messwerte
- 140: Vergleichsoperator Modellabbildung bezüglich der erweiterten Messwerte
- 150: Steuerungsbefehl für relevantes Netzgerät
- 160: Warnmeldung
- 170: Handlungsoption
- 180: Ermittlung der Netzstruktur

## Patentansprüche

1. Verfahren zur Überwachung eines Energieversorgungsnetzes, wobei das Energieversorgungsnetz mindestens eine Messeinrichtung (16) zur Messung von Messwerten (100, 101) mindestens einer Messgröße des Energieversorgungsnetzes aufweist und die Messwerte mindestens einer Messgröße gemessen und mit mindestens zwei unterschiedlichen Abtastraten mittels der Messeinrichtung (100, 101) ermittelt werden, wobei die mit der ersten Abtastrate abgetasteten Messwerte zur Erzeugung einer ersten Modellabbildung (110a) des Energieversorgungsnetzes und die mit der zweiten Abtastrate abgetasteten Messwerte zur Erzeugung mindestens einer zweiten Modellabbildung (110b) des Energieversorgungsnetzes genutzt werden,
und
anschließend aus den Modellabbildungen (110a, 110b) Netzzustände des Energieversorgungsnetzes abgeleitet werden, **dadurch gekennzeichnet, dass** die Netzzustände abgeleitet werden, in dem ein Grad der Übereinstimmung als ein Ähnlichkeitsmaß (120) zwischen der ersten und der zweiten Modellabbildung (110a, 110b) ermittelt wird.

2. Verfahren nach Anspruch 1,
**dadurch gekennzeichnet, dass** die Messwerte (100, 101) mindestens einer Messgröße des Energieversorgungsnetzes von mindestens einer zweiten Messeinrichtung (16) gemessen werden.

3. Verfahren nach einem der Ansprüche 1 bis 2,
**dadurch gekennzeichnet, dass** Messwerte (100, 101) mindestens zweier Messgrößen mit zwei unterschiedlichen Abtastraten ermittelt werden.

4. Verfahren nach einem der Ansprüche 1 bis 3,
**dadurch gekennzeichnet, dass** die Modellabbildungen (110a, 110b, 111) auf der Basis der Messwerte (100, 101) der mindestens einen Messgröße durch regelbasierte Systeme (13), insbesondere Expertensysteme, neuronale Netze und/oder Fuzzy-Logik-Systeme, abgeleitet werden.

5. Verfahren nach einem der Ansprüche 1 bis 4,
**dadurch gekennzeichnet, dass** die Modellabbildungen (110a, 110b) zu einem übergeordneten Modellabbild (111) des Energieversorgungsnetzes zusammengefasst werden.

6. Verfahren nach einem der Ansprüche 1 bis 5,
**dadurch gekennzeichnet, dass** die erste und/oder die zweite und/oder die übergeordnete Modellabbildung (110a, 110b, 111) mit archivierten Modellabbildungen (112) verglichen und im Falle der Übereinstimmung der ersten und/oder der zweiten und/oder der übergeordneten Modellabbildung (110a, 110b, 111) mit einer archivierten Modellabbildung (112) eines kritischen und/oder optimalen Netzzustandes ein priorisierte Zugriff auf die Messeinrichtung zur Ermittlung der aktuellen Messwerte (100, 101) erfolgt und anschließend die hieraus abgeleiteten Modellabbildungen (113) und/oder abgeleiteten Netzzustände mit relevanten archivierten Modellabbildungen (112) verglichen werden.

7. Verfahren nach einem der Ansprüche 5 oder 6,
**dadurch gekennzeichnet, dass** die erste und/oder die zweite und/oder die übergeordnete Modellabbildung (110a, 110b, 111) mit archivierten Modellabbildungen (112) verglichen und im Falle der Übereinstimmung der ersten und/oder der zweiten und/oder der übergeordneten Modellabbildung (110a, 110b, 111) mit einer archivierten Modellabbildung (112) eines kritischen Netzzustandes eine Warnmeldung (160) ausgegeben wird.

8. Verfahren nach einem der Ansprüche 5 bis 7,
**dadurch gekennzeichnet, dass** im Falle der Übereinstimmung der ersten und/oder der zweiten und/oder der übergeordneten Modellabbildung (110a, 110b, 111) mit einer archivierten Modellabbildung (112) eines kritischen Netzzustandes dem Bediener zur Überwachung des Energieversorgungsnetzes die aktuellen Messwerte (100, 101) und/oder die hieraus abgeleiteten Modellabbildungen (110a, 110b, 111) und/oder abgeleiteten Netzzustände direkt angezeigt werden.

9. Verfahren nach einem der Ansprüche 1 bis 8,
**dadurch gekennzeichnet, dass** aktuelle und/oder mögliche zukünftige Netzzustände des Energieversorgungsnetzes auf der Basis der Modellabbildungen (110a, 110b, 111) durch regelbasierte Systeme (13), insbesondere Expertensysteme, neuronale Netze und/oder Fuzzy-Logik-Systeme, berechnet werden.

10. Verfahren nach Anspruch 9,
**dadurch gekennzeichnet, dass** die berechneten aktuellen und/oder zukünftigen Netzzustände des Energieversorgungsnetzes visualisiert werden.

11. Verfahren nach einem der Ansprüche 1 bis 10,
**dadurch gekennzeichnet, dass** Handlungsoptionen (170) und/oder Steuerungsbefehle (150) für ein relevantes Netzgerät (15) auf der Basis von berechneten aktuellen und/oder zukünftigen Netzzuständen des Energieversorgungsnetzes durch regelbasierte Systeme (13), insbesondere Expertensysteme, neuronale Netze und/oder Fuzzy-Logik-Systeme, ermittelt werden.

12. Verfahren nach einem der Ansprüche 1 bis 11,
**dadurch gekennzeichnet, dass** die Messwerte (100, 101) an eine zentrale Recheneinheit (10) übermittelt und durch die zentrale Recheneinheit (10) die Modellabbildungen (110a, 110b, 111, 112), die aktuellen und/oder zukünftigen Netzzustände des Energieversorgungsnetzes und/oder die möglichen Handlungsoptionen (170) und/oder die möglichen Steuerungsbefehle (150) für das relevantes Netzgerät (15) berechnet werden.

13. Verfahren nach einem der Ansprüche 1 bis 12,
**dadurch gekennzeichnet, dass** die Messwerte (100, 101) innerhalb eines Kommunikationsnetzes zwischen mindestens zwei Recheneinheiten (10) übermittelt werden und durch eine Recheneinheit (10) mit verfügbarer Rechenkapazität die Modellabbildungen (110a, 110b, 111), die aktuellen und/oder zukünftigen Netzzustände des Energieversorgungsnetzes und/oder die möglichen Handlungsoptionen berechnet werden.

14. Verfahren nach einem der Ansprüche 1 bis 13,
**dadurch gekennzeichnet, dass** die Messwerte (100, 101) nach vorgegebenen Filterverfahren und Schwellwerten in der Messeinrichtung (16) gefiltert und die so gefilterten Messwerte (100, 101) mindestens einer Messgröße als Grundlage für die Generierung der Modelabbildungen (110a, 110b, 111) verwendet werden.

15. Verfahren nach einem der Ansprüche 1 bis 14,
**dadurch gekennzeichnet, dass** die Modellabbildungen (110a, 110b, 111) als Grundlage zur Berechnung eines Netzzuverlässigkeitsindizes als Maß für die Versorgungssicherheit und/oder Netzstabilität des Energieversorgungsnetzes verwendet werden.

16. Verfahren nach einem der Ansprüche 1 bis 15,
**dadurch gekennzeichnet, dass** die Messgröße der Phasenwinkel zwischen dem Strom und Spannung innerhalb des Energieversorgungsnetzes ist.

17. System zur Überwachung eines Energieversorgungsnetzes mit mindestens einer Messeinrichtung (16) zur Messung von Messwerten (10, 101) mindestens einer Messgröße des Energieversorgungsnetzes und die Messwerte (100, 101) der mindestens einen Messgröße in der Messeinrichtung (16) messbar und die Messwerte (100, 101) mit mindestens zwei unterschiedlichen Abtastraten abtastbar sind, wobei für eine Recheneinheit (10) die mit der ersten Abtastrate abgetasteten Messwerte (100, 101) zur Erzeugung einer ersten Modellabbildung (110a) des Energieversorgungsnetzes und die mit der zweiten Abtastrate abgetasteten Messwerte (100, 101) zur Erzeugung einer zweiten Modellabbildung (110b) des Energieversorgungsnetzes einlesbar und damit aus den Modellabbildungen (110a, 110b) Netzzustände des Energieversorgungsnetzes ableitbar sind, **dadurch gekennzeichnet, dass** die Recheneinheit (10) die erste und zweite Modellabbildung (110a, 110b) zu einem übergeordneten Modellabildung (111) zusammenfasst und nicht korrespondierende Modellregionen auf der Grundlage der ersten und zweiten Modellabbildung (110a, 110b, ) in der übergeordneten Modellabbildung (1101) ausgleicht.

18. System nach Anspruch 17,
**dadurch gekennzeichnet, dass** die Messeinrichtung (16) Bestandteil eines Phasenvektorgerätes (PMU) ist.

19. System nach einem der Ansprüche 17 oder 18,
**dadurch gekennzeichnet, dass** die Messeinrichtung (16) Bestandteil eines Schutzrelais ist.

20. System nach einem der Ansprüche 17 bis 18,
**dadurch gekennzeichnet, dass** die Messeinrichtung (16) Messwerte (100, 101) bezüglich des Energieversorgungsnetzes ermittelt und die Messwerte (100, 101) über ein Kommunikationsnetz verbreitet.

21. System nach einem der Ansprüche 17 bis 20,
**dadurch gekennzeichnet, dass** ein regelbasiertes System (13), insbesondere ein Expertensystem, ein neuronales Netz und/oder ein Fuzzy-Logik-System, ein Ähnlichkeitsmaß (120, 121) zwischen der ersten und zweiten Modellabbildung (110a, 110b) und/oder zwischen dem übergeordneten (111) und einer simulierten archivierten (112) Modellabbildung ermittelt.

22. System nach einem der Ansprüche 17 bis 21,
mit Mitteln zur Durchführung des Verfahrens nach einem der Ansprüche 1 bis 16.

23. Datenverarbeitungsprogramm zum Ausführen in einem Datenverarbeitungssystem, wobei das Datenverarbeitungsprogramm Teile eines Quellcodes zum Durchführen des Verfahrens nach einem der vorigen Ansprüche 1 bis 16 umfasst, wenn das Programm in einem Computer läuft.

24. Computerprogrammprodukt, das in einem computerlesbaren Medium gespeichert ist und computerlesbare Programmmittel umfasst, mittels derer ein Computer veranlasst wird, ein Verfahren nach einem der vorigen Ansprüche 1 bis 16 durchzuführen, wenn das Programm in dem Computer läuft.

## Claims

1. Method for monitoring a power supply system, wherein the power supply system has at least one measurement device (16) for measuring measured values (100, 101) of at least one measurement variable of the power supply system, and the measured values of at least one measurement variable are measured and are determined using at least two different sampling rates by means of the measurement device (100, 101), wherein the measured values sampled at the first sampling rate are used to produce a first model map (110a) of the power supply system, and the measured values sampled at the second sampling rate are used to produce at least one second model map (110b) of the power supply system,
and system states of the power supply system are then derived from the model maps (110a, 110b),
**characterized in that**
the system states are derived by determining a degree of match as a similarity measure (120) between the first and the second model maps (110a, 110b).

2. Method according to Claim 1,
**characterized in that**
the measured values (100, 101) of at least one measurement variable of the power supply system are measured by at least one second measurement device (16).

3. Method according to one of Claims 1 or 2,
**characterized in that**
measured values (100, 101) of at least two measurement variables are determined at two different sampling rates.

4. Method according to one of Claims 1 to 3,
**characterized in that**
the model maps (110a, 110b, 111) are derived on the basis of the measured values (100, 101) of the at least one measurement variable by control-based systems (13), in particular expert systems, neural networks and/or fuzzy logic systems.

5. Method according to one of Claims 1 to 4,
**characterized in that**
the model maps (110a, 110b) are combined to form a superordinate model map (111) of the power supply system.

6. Method according to one of Claims 1 to 5,
**characterized in that**
the first and/or the second and/or the superordinate model map (110a, 110b, 111) are/is compared with archived model maps (112) and, in the event of a match between the first and/or the second and/or the superordinate model map (110a, 110b, 111) and an archived model map (112) of a critical and/or optimum system state, prioritized access is provided to the measurement device in order to determine the instantaneous measured values (100, 101), and the model maps (113) derived therefrom, and/or derived system states, are then compared with relevant archived model maps (112).

7. Method according to one of Claims 5 or 6,
**characterized in that**
the first and/or the second and/or the superordinate model map (110a, 110b, 111) are/is compared with archived model maps (112) and, if there is a match between the first and/or the second and/or the superordinate model map (110a, 110b, 111) and an archived model map (112) of a critical system state, a warning message (160) is emitted.

8. Method according to one of Claims 5 to 7,
**characterized in that,**
if there is a match between the first and/or the second and/or the superordinate model map (110a, 110b, 111) and an archived model map (112) of a critical system state, the instantaneous measured values (100, 101) and/or the model maps (110a, 110b, 111) derived therefrom and/or derived system states are indicated directly to the operator for the purpose of monitoring the power supply system.

9. Method according to one of Claims 1 to 8,
**characterized in that**
instantaneous and/or possible future system states of the power supply system are calculated on the basis of the model maps (110a, 110b, 111) by control-based systems (13), in particular expert systems, neural networks and/or fuzzy logic systems.

10. Method according to Claim 9,
**characterized in that**
the calculated instantaneous and/or future system states of the power supply system are visualized.

11. Method according to one of Claims 1 to 10,
**characterized in that**
handling options (170) and/or control commands (150) for a relevant power supply unit (15) are determined on the basis of calculated instantaneous and/or future system states of the power supply system by control-based systems (13), in particular expert systems, neural networks and/or fuzzy logic systems.

12. Method according to one of Claims 1 to 11,
**characterized in that**
the measured values (100, 101) are transmitted to a central computation unit (10), and the central computation unit (10) calculates the model maps (110a, 110b, 111, 112), the instantaneous and/or future system states of the power supply system and/or the possible handling options (170) and/or the possible control commands (150) for the relevant power supply unit (15).

13. Method according to one of Claims 1 to 12,
**characterized in that**
the measured values (100, 101) are transmitted between at least two computation units (10) within a communication network, and a computation unit (10) with available computation capacity calculates the model maps (110a, 110b, 111), the instantaneous and/or future system states of the power supply system, and/or the possible handling options.

14. Method according to one of Claims 1 to 13,
**characterized in that**
the measured values (100, 101) are filtered on the basis of predetermined filter methods and threshold values in the measurement device (16), and the measured values (100, 101) of at least one measurement variable which have been filtered in this way are used as the basis for generating the model maps (110a, 110b, 111).

15. Method according to one of Claims 1 to 14,
**characterized in that**
the model maps (110a, 110b, 111) are used as the basis for calculating a system reliability index as a measure of the supply reliability and/or system stability of the power supply system.

16. Method according to one of Claims 1 to 15,
**characterized in that**
the measurement variable is the phase angle between the current and the voltage within the power supply system.

17. System for monitoring a power supply system having at least one measurement device (16) for measurement of measured values (10, 101) of at least one measurement variable of the power supply system, and the measured values (100, 101) of the at least one measurement variable can be measured in the measurement device (16), and the measured values (100, 101) can be sampled at at least two different sampling rates, wherein the measured values (100, 101) sampled at the first sampling rate can be read in in order to produce a first model map (110a) of the power supply system, and the measured values (100, 101) sampled at the second sampling rate can be read in in order to produce a second model map (110b) of the power supply system, for a computation unit (10), and system states of the power supply system can thus be derived from the model maps (110a, 110b),
**characterized in that**
the computation unit (10) combines the first and the second model maps (110a, 110b) to form a superordinate model map (111), and model regions which do not correspond are compensated for on the basis of the first and second model maps (110a, 110b) in the superordinate model map (111).

18. System according to Claim 17,
**characterized in that**
the measurement device (16) is a component of a phase vector appliance (PMU).

19. System according to one of Claims 17 or 18,
**characterized in that**
the measurement device (16) is a component of a protective relay.

20. System according to one of Claims 17 or 18,
**characterized in that**
the measurement device (16) determines measured values (100, 101) relating to the power supply system, and disseminates the measured values (100, 101) via a communication network.

21. System according to one of Claims 17 to 20,
**characterized in that**
a control-based system (13), in particular an expert system, a neural network and/or a fuzzy logic system determines a similarity measure (120, 121) between the first and the second model maps (110a, 110b) and/or between the superordinate model map (111) and a simulated archived model map (112).

22. System according to one of Claims 17 to 21, having means for carrying out the method according to one of Claims 1 to 16.

23. Data processing program for running in a data processing system, wherein the data processing program comprises parts of a source code for carrying out the method according to one of the preceding Claims 1 to 16 when the program is run in a computer.

24. Computer program product, which is stored in a computer-legible medium and comprises computer-legible program means which cause a computer to carry out a method according to one of the preceding Claims 1 to 16 when the program is run in the computer.

## Revendications

1. Procédé de contrôle d'un réseau d'alimentation en énergie, le réseau d'alimentation en énergie ayant au moins un dispositif ( 16 ) de mesure pour la mesure de valeurs ( 100, 101 ) de mesure d'au moins une grandeur de mesure du réseau d'alimentation en énergie et les valeurs de mesure d'au moins une grandeur de mesure étant mesurées et déterminées au moyen du dispositif ( 100, 101) de mesure à au moins deux fréquences d'échantillonnage différentes, les valeurs de mesure échantillonnées à la première fréquence d'échantillonnage étant utilisées pour la production d'une première reproduction (110a) par modèle du réseau d'alimentation en énergie et les valeurs de mesure échantillonnées à la deuxième fréquence d'échantillonnage peuvent être lues pour la production d'au moins une deuxième reproduction ( 110b) par modèle du réseau d'alimentation en énergie et des états du réseau d'alimentation en énergie étant ensuite déduits des reproductions ( 110a, 110b) par modèle, **caractérisé en ce que**
l'on déduit les états du réseau en déterminant un degré de coïncidence comme une mesure ( 120) de similitude entre la première et la deuxième reproductions (110a, 110b) par modèle.

2. Procédé suivant la revendication 1,
**caractérisé en ce que**
l'on mesure les valeurs ( 100, 101 ) de mesure d'au moins une grandeur de mesure du réseau d'alimentation en énergie par au moins un deuxième dispositif ( 16 ) de mesure.

3. Procédé suivant l'une des revendications 1 à 2, **caractérisé en ce que**
l'on détermine des valeurs ( 100, 101 ) de mesure d'au moins deux grandeurs de mesure à deux fréquences d'échantillonnage différentes.

4. Procédé suivant l'une des revendications 1 à 3, **caractérisé en ce que**
l'on déduit les reproductions ( 110a, 110b, 111 ) par modèle sur la base des valeurs ( 100, 101 ) de mesure de la au moins une grandeur de mesure par des systèmes ( 13 ) à base de règles, notamment des systèmes experts, des systèmes neuronaux et/ou des systèmes à logique floue.

5. Procédé suivant l'une des revendications 1 à 4, **caractérisé en ce que**
l'on rassemble les reproductions ( 110a, 110b) par modèle en une reproduction (111) par modèle supérieure hiérarchiquement du réseau d'alimentation en énergie.

6. Procédé suivant l'une des revendications 1 à 5, **caractérisé en ce que**
l'on compare la première reproduction (110a) et/ou la deuxième reproduction (110b) et/ou la reproduction ( 111 ) par modèle supérieure hiérarchiquement à des reproductions ( 112 ) par modèle archivées et, dans le cas où la première et/ou la deuxième et/ou la reproduction ( 110a, 110b, 111 ) par modèle supérieure hiérarchiquement coïncide avec une reproduction ( 112 ) par modèle archivée d'un état du réseau critique et/ou optimum, l'on effectue un accès en priorité au dispositif de mesure pour la détermination des valeurs ( 100, 101 ) instantanées de mesure et l'on compare ensuite les reproductions ( 113 ) par modèle qui s'en déduisent et/ou les états de réseau qui s'en déduisent à des reproductions ( 112 ) par modèle archivées pertinentes.

7. Procédé suivant l'une des revendications 1 ou 6, **caractérisé en ce que**
l'on compare la première reproduction (110a) et/ou la deuxième reproduction (110b) et/ou la troisième reproduction ( 111 ) par modèle supérieure hiérarchiquement à des reproductions ( 112 ) par modèle archivées et, si la première reproduction (110a) et/ou la deuxième reproduction (110b) et/ou la reproduction ( 111 ) par modèle supérieure hiérarchiquement coïncide avec une reproduction ( 112 ) par modèle archivée d'un état de réseau critique, l'on émet une indication ( 160 ) d'avertissement.

8. Procédé suivant l'une des revendications 5 à 7, **caractérisé en ce que**
si la première reproduction (110a) et/ou la deuxième reproduction (110b) et/ou la reproduction ( 111 ) par modèle supérieure hiérarchiquement coïncide avec une reproduction ( 112 ) par modèle archivée d'un état du réseau critique, l'on indique directement à l'opérateur, pour le contrôle du réseau d'alimentation en énergie, les valeurs ( 100, 101 ) de mesure instantanées et/ou les reproductions ( 110a, 110b, 111 ) par modèle qui s'en déduisent et/ou les états du réseau qui s'en déduisent.

9. Procédé suivant l'une des revendications 1 à 8, **caractérisé en ce que**
l'on calcule des états du réseau de l'alimentation en énergie instantanés, ou éventuellement à venir, sur la base des reproductions ( 110a, 110b, 111 ) par modèle par des systèmes ( 13 ) à base de règles, notamment par des systèmes experts, par des réseaux neuronaux et/ou par des systèmes de logique floue.

10. Procédé suivant la revendication 9,
**caractérisé en ce que**
l'on visualise les états du réseau d'alimentation en énergie calculés instantanés et/ou à venir.

11. Procédé suivant l'une des revendications 1 à 10, **caractérisé en ce que**
l'on détermine des options ( 170 ) de manoeuvre et/ou des instructions ( 150 ) de commande pour un appareil ( 15 ) de réseau pertinent sur la base d'états du réseau d'alimentation en énergie calculés instantanés et/ou à venir par des systèmes ( 13 ) à base de règles, notamment par des systèmes experts, par des réseaux neuronaux et/ou par des systèmes de logique floue.

12. Procédé suivant l'une des revendications 1 à 11, **caractérisé en ce que**
l'on transmet les valeurs ( 100, 101 ) de mesure à une unité ( 10 ) informatique centrale et l'on calcule par l'unité ( 10 ) informatique centrale les reproductions ( 110a, 110b, 111, 112 ) par modèle, les états du réseau d'alimentation en énergie instantanés et/ou à venir et/ou les options ( 170 ) de manoeuvre possibles et/ou les instructions ( 150 ) de commande possibles pour l'appareil ( 15 ) de réseau pertinent.

13. Procédé suivant l'une des revendications 1 à 12, **caractérisé en ce que**
l'on transmet les valeurs ( 100, 101 ) de mesure au sein d'un réseau de communication entre au moins deux unités ( 10 ) informatiques et l'on calcule, par une unité ( 10 ) informatique ayant de la capacité de calcul disponible, des reproductions ( 110a, 110b, 111 ) par modèle, les états du réseau d'alimentation en énergie instantanés et/ou à venir et/ou les options de manoeuvré possibles.

14. Procédé suivant l'une des revendications 1 à 13, **caractérisé en ce que**
l'on filtre les valeurs ( 100, 101 ) de mesure par des procédés de filtrage et par des valeurs de seuil prescrites dans le dispositif ( 16 ) de mesure et l'on utilise des valeurs ( 100, 101 ) de mesure ainsi filtrées d'au moins une grandeur de mesure comme bases pour la production des reproductions ( 110a, 110b, 111 ) par modèle.

15. Procédé suivant l'une des revendications 1 à 14, **caractérisé en ce que**
l'on utilise les reproductions ( 110a, 110b, 111 ) par modèle comme bases pour le calcul d'un indice de fiabilité du réseau en tant que mesure de la sécurité d'alimentation et/ou de la stabilité du réseau d'alimentation en énergie.

16. Procédé suivant l'une des revendications 1 à 15, **caractérisé en ce que**
la grandeur de mesure est l'angle de phase entre le courant et la tension dans le réseau d'alimentation en énergie.

17. Système de contrôle d'un réseau d'alimentation en énergie, comprenant au moins un dispositif ( 16 ) de mesure pour la mesure de valeurs ( 100, 101 ) de mesure d'au moins une grandeur de mesure du réseau d'alimentation en énergie et les valeurs ( 100, 101 ) de mesure de la au moins une grandeur de mesure peuvent être mesurées dans le dispositif ( 16 ) de mesure et les valeurs ( 100, 101 ) de mesure peuvent être échantillonnées à au moins deux fréquences d'échantillonnage différentes, dans lequel, pour une unité ( 10 ) informatique, les valeurs ( 100, 101 ) de mesure échantillonnées à la première fréquence d'échantillonnage peuvent être lues pour la production d'une première reproduction ( 110a ) par modèle du réseau d'alimentation en énergie et les valeurs ( 100, 101 ) de mesure échantillonnées à la deuxième fréquence d'échantillonnage peuvent être lues pour la production d'une deuxième reproduction ( 110b ) par modèle du réseau d'alimentation en énergie et des états du réseau d'alimentation en énergie peuvent ainsi être déduits des reproductions ( 110a, 110b ) par modèle,
**caractérisé en ce que**
l'unité ( 10 ) informatique rassemble la première et la deuxième reproductions ( 110a, 110b ) par modèle en une reproduction ( 111 ) par modèle supérieure hiérarchiquement et des régions du modèle, qui ne se correspondent pas sur la base de la première et de la deuxième reproductions ( 110a, 110b ) par modèle, sont comparées dans la reproduction ( 111 ) par modèle supérieure hiérarchiquement.

18. Système suivant la revendication 17,
**caractérisé en ce que**
le dispositif ( 16 ) de mesure fait partie d'un appareil ( PMU ) de vecteur de phase.

19. Système suivant l'une des revendications 17 ou 18, **caractérisé en ce que**
le dispositif ( 16 ) de mesure fait partie d'un relais de protection.

20. Système suivant l'une des revendications 17 à 18, **caractérisé en ce que**
le dispositif ( 16 ) de mesure détermine des valeurs ( 100, 101 ) de mesure concernant le réseau d'alimentation en énergie et diffuse des valeurs ( 100, 101 ) de mesure par un réseau de communication.

21. Système suivant l'une des revendications 17 à 20, **caractérisé en ce que**
un système ( 13 ) à base de règles, notamment un système expert, un réseau neuronal et/ou un système de logique floue, détermine une mesure ( 120, 121 ) de similitude entre la première et la deuxième reproductions ( 110a, 110b ) par modèle et/ou entre la reproduction par modèle supérieure hiérarchiquement ( 111 ) et une reproduction par modèle archivée ( 112 ) simulée.

22. Système suivant l'une des revendications 17 à 21, comprenant des moyens pour effectuer le procédé suivant l'une des revendications 1 à 16.

23. Programme informatique à exécuter dans un système informatique, dans lequel le programme informatique comprend des parties d'un code source, pour effectuer le procédé suivant l'une des revendications 1 à 16 précédentes, lorsque le programme passe dans un ordinateur.

24. Produit de programme informatique qui est mémorisé dans un support pouvant être lu par un ordinateur et qui comprend des moyens de programme pouvant être lus par un ordinateur au moyen desquels il est fait en sorte qu'un ordinateur effectue un procédé suivant l'une des revendications précédentes 1 à 16 lorsque le programme passe dans l'ordinateur.
